**Europäisches Patentamt**

**European Patent Office**

**Office européen des brevets**

(11) Veröffentlichungsnummer: **0 218 820**
**A1**

# EUROPÄISCHE PATENTANMELDUNG

(21) Anmeldenummer: 86110269.7

(22) Anmeldetag: 25.07.86

(51) Int. Cl.⁴: **G 01 R 31/32**

(30) Priorität: 26.09.85 CH 4167/85

(43) Veröffentlichungstag der Anmeldung:
**22.04.87** Patentblatt **87/17**

(84) Benannte Vertragsstaaten:
**CH DE IT LI NL**

(71) Anmelder: **BBC Aktiengesellschaft Brown, Boveri & Cie.**
**Haselstrasse**
**CH-5401 Baden(CH)**

(72) Erfinder: **Fröhlich, Klaus, Dr. Dipl.-Ing.**
**Baldeggstrasse 11**
**CH-5400 Baden(CH)**

(54) **Prüfkreis.**

(57) Dieser Prüfkreis für die synthetische Prüfung des Ausschaltvermögens eines Hochspannungs-Leistungsschalters (9) setzt sich aus einem Hochstromkreis (1) und einem über eine Funkenstrecke (20) zuschaltbaren Hochspannungskreis (2), welcher eine aufladbare Hochspannungsquelle (24) enthält, zusammen.

Ein vergleichsweise einfach zu realisierender Prüfkreis soll geschaffen werden, welcher insbesondere für die Prüfung des dielektrischen Verhaltens der Schaltstrecke des Hochspannungs-Leistungsschalters geeignet ist.

Dies wird dadurch erreicht, dass die Hochspannungsquelle (24) ausgebildet ist als Marx'scher Stossgenerator mit Kapazitäten ($C_1 \ldots C_4$), die mittels Hilfsfunkenstrecken ($F_1 \ldots F_3$) gleichzeitig in Reihe schaltbar sind. Die durch das Zusammenschalten der Kapazitäten ($C_1 \ldots C_4$) erzeugte Hochspannung zündet die Funkenstrecke (20) und beaufschlagt danach den zu prüfenden Hochspannungs-Leistungsschalter (9).

FIG. 1

0218820

96/85

26.9.85
Se/SC

- 1 -


## Prüfkreis


Die Erfindung betrifft einen Prüfkreis gemäss dem ersten Teil des Anspruchs 1.

Aus der IEC-Publication 427 (Jahrgang 1973, Seite 79) ist ein Prüfkreis für die synthetische Prüfung des Ausschaltvermögens von Hochspannungs-Leistungsschaltern bekannt. Dieser Prüfkreis weist einen Hochstromkreis mit einem Hilfsschalter und einem Prüfschalter in Serie auf, sowie einen Hochspannungskreis parallel zum Prüfschalter. Im Hochspannungskreis ist eine mit Gleichspannung aufladbare Kondensatorbatterie als Hochspannungsquelle vorgesehen, ferner eine Induktivität in Serie zu der Kondensatorbatterie und eine Kapazität parallel zum Versuchsschalter. Eine triggerbare Funkenstrecke erlaubt es, den Hochspannungskreis im richtigen Augenblick auf den Prüfschalter draufzuschalten. Eine weitere Kapazität ist parallel zum Hilfsschalter geschaltet, welche wesentlich grösser ist als die Kapazität parallel zum Prüfschalter.
Bei einer Leistungsabschaltung fliesst zunächst der volle Prüfstrom durch den Hochstromkreis. Der Prüf- und der Hilfsschalter unterbrechen diesen Prüfstrom in einem vorausbestimmten Stromnulldurchgang. Die treibende Spannung

des Hochstromkreises wird nun durch die beiden Kapazitäten so über Prüf- und Hilfsschalter verteilt, dass der überwiegende Teil dieser Spannung an der Schaltstrecke des Prüfschalters liegt und den ersten Teil des Anstieges der transienten wiederkehrenden Spannung bildet. Unmittelbar danach wird der Hochspannungskreis mittels der triggerbaren Funkenstrecke zugeschaltet und liefert die weiteren Anteile der transienten wiederkehrenden Spannung.

Der Aufbau dieses Prüfkreises ist vergleichsweise aufwendig. Für den Schutz des Hochstromkreises gegen die Spannung des Hochspannungskreises, welche von der energiereichen Kondensatorbatterie gespeist wird, müssen aufwendige Massnahmen getroffen werden. Für die Aufladung der Kondensatorbatterie ist eine, für die volle Prüfspannung ausgelegte und deshalb sehr teure Ladeeinrichtung nötig.

Hier will die Erfindung Abhilfe schaffen. Die Erfindung, wie sie in den Ansprüchen gekennzeichnet ist, löst die Aufgabe einen einfacher und kostengünstiger zu realisierenden Prüfkreis für die Prüfung von Hochspannungs-Leistungsschaltern zu schaffen, welcher insbesondere für die Prüfung des dielektrischen Verhaltens der sich öffnenden Schaltstrecke geeignet ist.

Der Vorteil der Erfindung ist darin zu sehen, dass keine Kondensatorbatterie mit grossem Energieinhalt und teurem, für die volle Prüfspannung ausgelegtem Ladekreis eingesetzt zu werden braucht. Der erfindungsgemässe Prüfkreis kann auch leicht und ohne aufwendige Umbauten für andere Prüfspannungswerte umgerüstet werden. Ferner kann die Kapazität parallel zum Hilfsschalter eingespart werden.

Die weiteren Ausgestaltungen der Erfindung sind Gegenstände der abhängigen Ansprüche.

Im folgenden wird die Erfindung anhand der Zeichnungen näher erläutert.

Es zeigt:

Fig. 1 eine erste Ausführungsform des erfindungsgemässen Prüfkreises und

Fig. 2 ein Detail einer zweiten Ausführungsform dieses Prüfkreises.

Bei beiden Figuren sind gleich wirkende Elemente mit gleichen Bezugszeichen versehen.

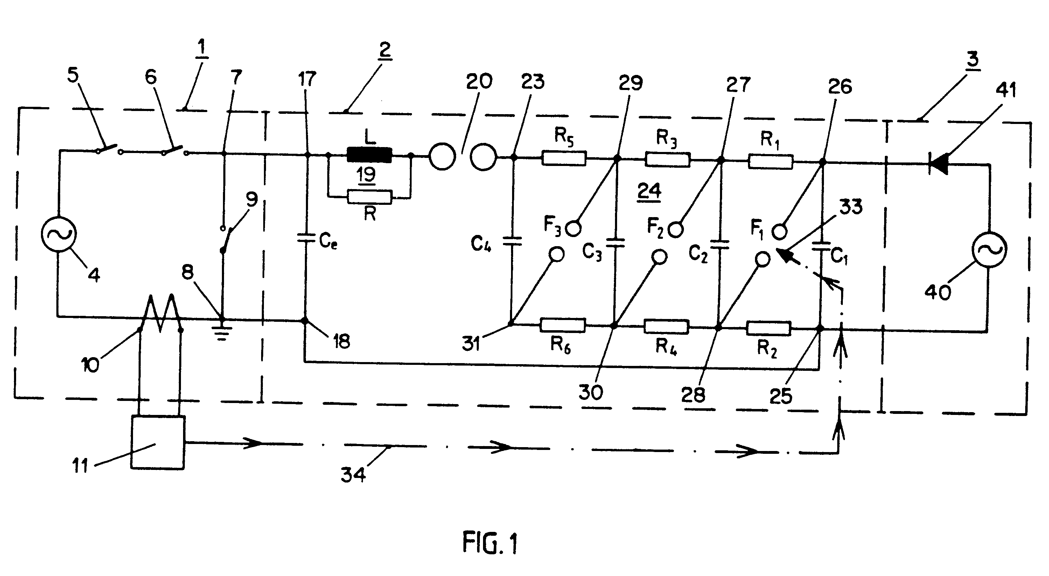

In der Figur 1 ist der aus einem Hochstromkreis 1, einem Hochspannungskreis 2 und einem abtrennbaren Ladekreis 3 bestehende Prüfkreis dargestellt. Der Hochstromkreis 1 besteht aus einer Hochstromquelle 4, die in Reihe geschaltet ist mit einem Draufschalter 5, einem Hilfsschalter 6 und einem zwischen Abgangsklemmen 7,8 des Hochstromkreises 1 geschalteten Hochspannungs-Leistungsschalter als Prüfschalter 9. Ueber einen als Stromwandler ausgebildeten Sensor 10 werden bei geschlossenem Hochstromkreis 1 stromproportionale Signale abgegriffen und in eine elektronische Steuereinheit 11 zur weiteren Verarbeitung geleitet. Die Abgangsklemme 7 des Hochstromkreises 1 ist mit der Klemme 17 des Hochspannungskreises 2 leitend verbunden, ebenso die in der Regel geerdete Abgangsklemme 8 mit der entsprechenden Klemme 18. Zwischen den Klemmen 17, 18 liegt eine Kapazität $C_e$, die mindestens 2 bis 5 nF aufweisen muss, parallel zum Prüfschalter 9. Die Klemme 17 ist mit einem Dämpfungsglied 19 verbunden, welches aus der Parallelschaltung einer Induktivität L und eines ohmschen Widerstandes R besteht. Die der Klemme 17 abgewandte Seite
des Dämpfungsgliedes 19 ist mit einem Pol einer Funkenstrecke 20 verbunden. Ein zweiter Pol der Funkenstrecke
20 ist mit einer hochspannungsseitigen Abgangsklemme 23
einer Hochspannungsquelle 24 für quasi-stationäre Gleichspannung verbunden, deren andere Abgangsklemme, bezeichnet
als Klemme 25, mit der Klemme 18 leitend verbunden ist.

Die Hochspannungsquelle ist als Stossgenerator ausgebildet.
Eine Kapazität $C_1$ des Stossgenerators weist die Klemmen
26 und 25 auf. Die Klemme 26 ist über einen Ladewiderstand
$R_1$ mit einer Klemme 27 einer Kapazität $C_2$ verbunden und
die Klemme 25 über einen Ladewiderstand $R_2$ mit einer Klemme
28 der Kapazität $C_2$. Zwischen die Klemme 26 der Kapazität
$C_1$ und die Klemme 28 der Kapazität $C_2$ ist eine Hilfsfunkenstrecke $F_1$ geschaltet. Die Klemme 27 der Kapazität
$C_2$ ist über einen Ladewiderstand $R_3$ mit einer Klemme 29
einer Kapazität $C_3$ und die Klemme 28 der Kapazität $C_2$
ist über einen Ladewiderstand $R_4$ mit einer Klemme 30 der
Kapazität $C_3$ verbunden. Zwischen die Klemme 27 der Kapazität
$C_2$ und die Klemme 30 der Kapazität $C_3$ ist eine Hilfsfunkenstrecke $F_2$ geschaltet. Die Klemme 29 der Kapazität $C_3$
ist über einen Ladewiderstand $R_5$ mit der Abgangsklemme
23 verbunden, welche gleichzeitig mit einer Kapazität
$C_4$ verbunden ist. Die Klemme 30 der Kapazität $C_3$ ist über
einen Ladewiderstand $R_6$ mit einer Klemme 31 der Kapazität
$C_4$ verbunden. Zwischen die Klemme 29 der Kapazität $C_3$
und die Klemme 31 der Kapazität $C_4$ ist eine Hilfsfunkenstrecke $F_3$ geschaltet.

Mindestens eine der drei Hilfsfunkenstrecken $F_1$, $F_2$, $F_3$
ist vom Sensor 10 her triggerbar ausgeführt. Hier ist
dies beispielsweise die Hilfsfunkenstrecke $F_1$, welche
eine durch einen Pfeil 33 angedeutete Zündelektrode aufweist, welche von der Steuereinheit 11 her entsprechend der Wirkungslinie 34 zeitgenau zum Ansprechen gebracht wird.

Dieser Stossgenerator kann beliebig um weitere gleichartige Schaltkreise erweitert, er kann aber auch mit reduziertem Aufwand, z.B. nur mit der Kapazität $C_1$ und der Kapazität $C_2$ und der diesen zugehörigen weiteren Beschaltung ausgeführt werden. Vorteilhaft lässt sich der Stossgenerator ausbilden, wenn alle Ladewiderstände $R_1$ bis $R_6$ den gleichen Widerstandswert im Bereich von mindestens 10 Kiloohm bis 10 Megaohm aufweisen und alle Kapazitäten $C_1$ bis $C_4$ den gleichen Kapazitätswert. Dabei muss jedoch der aus einer Reihenschaltung der Kapazitäten $C_1$ bis $C_4$ sich ergebende Kapazitätswert mindestens um das Fünf- bis Zehnfache über dem Wert der Kapazität $C_e$ liegen. Diese Forderung gilt auch, wenn lediglich zwei Kapazitäten $C_1$, $C_2$ zu einem Stossgenerator zusammengeschaltet sind.

An die Klemmen 25 und 26 der Hochspannungsquelle 24 wird der Ladekreis 3 angelegt, der eine Wechselspannungsquelle 40 und eine Gleichrichteranordnung 41 enthält. Der Ladekreis kann über nicht dargestellte Trennelemente vom Hochspannungskreis 2 getrennt werden, er kann aber auch, wenn ein hinreichend grosser Ladewiderstand in Reihe zur Gleichrichteranordnung 41 geschaltet wird, dauernd angeschlossen bleiben.

Zur Erläuterung der Wirkungsweise des Prüfkreises sei die Figur 1 betrachtet. Die Hochspannungsquelle 24 wird vom Ladekreis 3 her aufgeladen. Die Hilfsfunkenstrecken $F_1$ bis $F_3$ und auch die Funkenstrecke 20 sind so eingestellt, dass sie bei der Aufladespannung noch nicht durchzünden können. Die Kapazitäten $C_1$ bis $C_4$ werden in der Regel auf die gleiche Ladespannung aufgeladen, danach wird der Ladekreis 3 abgetrennt. Im Hochstromkreis 3 schaltet der Draufschalter 5 den Prüfstrom ein, der durch den
geschlossenen Hilfsschalter 6 und den gleichfalls geschlossenen Prüfschalter 9 fliesst. Der Sensor 10 gibt ein dem
Prüfstrom proportionales Messignal in die elektronische
Steuereinheit 11 ab. Der Hilfsschalter 6 und der Prüfschalter 9 unterbrechen im vorbestimmten Nulldurchgang
den Prüfstrom. Auf diesen Nulldurchgang bezogen gibt die
Steuereinheit 11 ein Triggersignal ab, welches, wie durch
die Wirkungslinie 34 angedeutet, auf die Hilfsfunkenstrecke
$F_1$ einwirkt und diese Hilfsfunkenstrecke $F_1$ zum Durchzünden
bringt. Innerhalb einer Microsekunde zünden nun auch die
Hilfsfunkenstrecken $F_2$ und $F_3$ ebenfalls durch und schalten
entsprechend dem Prinzip des Marx'schen Stossgenerators
die aufgeladenen Kapazitäten $C_1$ bis $C_4$ in Reihe. Zwischen
den Abgangsklemmen 23 und 25 steht nun die vierfache Ladespannung als Prüfspannung zur Verfügung. Diese Prüfspannung
ist eine quasi-stationäre Gleichspannung.

Durch diese hohe Prüfspannung wird die Funkenstrecke 20
zum Durchzünden gebracht. Mit dem Durchzünden der Funkenstrecke 20 ist der Hochspannungskreis 2 geschlossen und
über dem Kondensator $C_e$ baut sich die volle transiente
Prüfspannung auf und beansprucht den Prüfschalter 9. Das
Triggersignal für das Durchzünden der Hilfsfunkenstrecke
$F_1$ wird in der Regel zeitlich so abgestimmt, dass 2 bis
60 Microsekunden nach dem Abschalten des Prüfstromes der
Spannungsanstieg über dem Prüfschalter beginnt. Die transiente Prüfspannung schwingt mit einer Frequenz, welche
mittels des Dämpfungsgliedes 19 und der Grösse der Kapazitäten $C_e$ und $C_1$ bis $C_4$ eingestellt werden kann, um den
Maximalwert der Prüfspannung.

Die gleiche Dämpfung wie durch das Dämpfungsglied 19 kann
auch erreicht werden, wenn anstelle des Dämpfungsgliedes
19 lediglich eine Induktivität in den Hochspannungskreis 2 geschaltet wird und wenn gleichzeitig ein entsprechend abgestimmter ohmscher Widerstand in Reihe zur Kapazität $C_e$ gelegt wird.

Die Funkenstrecke 20 und die Hilfsfunkenstrecken $F_1$ bis $F_3$ werden, um leicht überschaubare Zündverhältnisse zu schaffen, vorteilhaft auf die gleiche, etwas oberhalb der Ladespannung liegende Zündspannung eingestellt. Es gibt jedoch auch andere Varianten der Zündspannungseinstellung.

Bei einer Hochspannungsquelle 24 mit einem Stossgenerator, welcher lediglich mit zwei Kapazitäten $C_1$ und $C_2$ beschaltet ist, wird die Zündspannung der Hilfsfunkenstrecke $F_1$ auf einen Wert etwas oberhalb der Ladespannung eingestellt, die Zündspannung der Funkenstrecke 20 kann dagegen zwischen diesem Wert und einem Wert der etwas kleiner ist als die Summe der Ladespannungen der beiden Kapazitäten $C_1$ und $C_2$ liegen. Bei einem Stossgenerator, der mit drei Kapazitäten $C_1$ bis $C_3$ beschaltet ist, liegt die Zündspannung für die erste Hilfsfunkenstrecke $F_1$ ebenfalls etwas oberhalb der Ladespannung, die Zündspannung der zweiten Hilfsfunkenstrecke $F_2$ kann zwischen diesem Wert und einem Wert der etwas kleiner ist als die Summe der Ladespannungen der beiden Kapazitäten $C_1$ und $C_2$ liegen. Die Zündspannung der Funkenstrecke 20 kann in diesem Fall zwischen einem Wert etwas oberhalb der Ladespannung und einem Wert der etwas kleiner ist als die Summe der Ladespannungen der drei Kapazitäten $C_1$, $C_2$ und $C_3$ eingestellt werden.

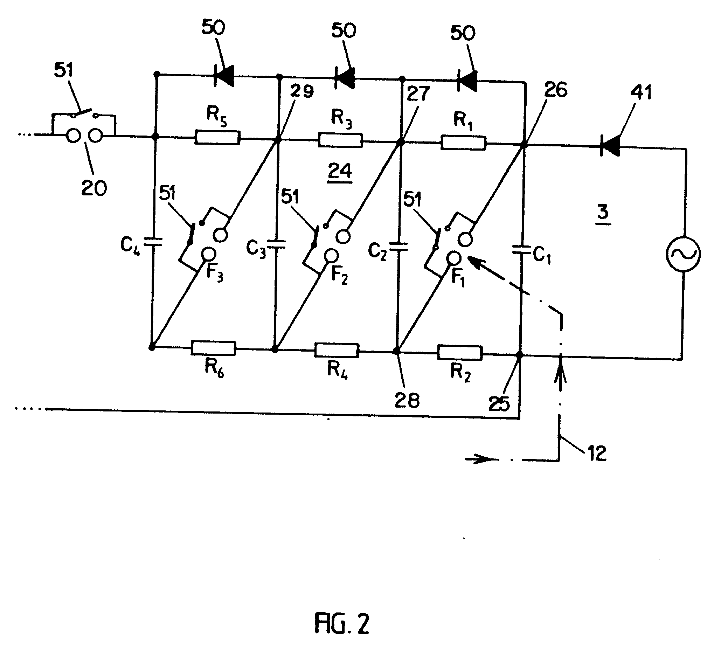

In der Figur 2 sind im Hochspannungskreis Modifikationen eingezeichnet, welche die Arbeitsweise desselben verbessern. Zu den Ladewiderständen $R_1$, $R_3$ und $R_5$ ist je eine Diode 50 parallelgeschaltet. Die Durchlassrichtung dieser Dioden 50 ist identisch mit der Durchlassrichtung der Gleichrichteranordnung 41 des Ladekreises 3. Durch den Einbau der Dioden 50 kann die Ladezeitkonstante für das Aufladen der Kapazitäten $C_1$ bis $C_4$ halbiert werden und so die Verfügbarkeit der Hochspannungsquelle 24 erhöht werden.

Ferner sind in der Figur 2 Trenner 51 eingezeichnet, welche die Funkenstrecke 20 und die Hilfsfunkenstrecken $F_1$ bis $F_3$ überbrücken können. Diese Trenner 51 werden zeitlich so gesteuert, dass sie ca. 2 bis 8 Millisekunden nach dem vorbestimmten Unterbrechen des Hochstromkreises einschalten und die erwähnten Funkenstrecken überbrücken. Für das Aufrechterhalten der Funkenentladung in den Funkenstrecken wird bei abnehmender Stromstärke eine immer grösser werdende treibende Spannung benötigt. Dieses Ansteigen der treibenden Spannung wird nun durch das leitende Ueberbrücken der Funkenstrecken vermieden.

Auch bei einem Hochspannungskreis, welcher einen mit lediglich zwei Kapazitäten $C_1$ und $C_2$ beschalteten Stossgenerator aufweist, kann parallel zum Ladewiderstand $R_1$ eine Diode 50 vorgesehen werden, welche in Richtung von der Klemme 26 der Kapazität $C_1$ in Richtung auf die Klemme 27 der Kapazität $C_2$ für angelegte Gleichspannung durchlässig ist. Ebenso können auch bei dieser Anordnung die Funkenstrecke 20 und die Hilfsfunkenstrecke $F_1$ vorteilhaft mit Trennern 51 überbrückt werden.

Der angegebene Prüfkreis lässt sich relativ einfach und kostengünstig realisieren und ist besonders in der Entwicklungsphase eines Hochspannungs-Leistungsschalters sehr sinnvoll einzusetzen, da sich die Prüfkreisparameter, insbesondere die Prüfspannung, ohne grossen Aufwand verändern lassen.

Ferner bietet sich dieser Prüfkreis an zur einfachen Bestimmung der zeitlichen Abhängigkeit des Anstiegs der
Spannungsfestigkeit in der Schaltstrecke des geprüften
Hochspannungs-Leistungsschalters.

P a t e n t a n s p r ü c h e

1. Prüfkreis für die synthetische Prüfung des Ausschaltvermögens von Hochspannungs-Leistungsschaltern mit einem einen Hilfsschalter (6), einen Prüfschalter (9) und einen Sensor (10) enthaltenden Hochstromkreis (1) und mit mindestens einem mittels einer Funkenstrecke (20) zuschaltbaren Hochspannungskreis (2), welcher mindestens eine mit Gleichspannung aufladbare Hochspannungsquelle (24) enthält, dadurch gekennzeichnet,

- dass die mindestens eine Hochspannungsquelle (24) ausgebildet ist als Stossgenerator mit mindestens zwei parallelgeschalteten Kapazitäten ($C_1$, $C_2$) und mindestens einer, vom Sensor (10) her triggerbaren und zwischen die mindestens zwei Kapazitäten ($C_1$, $C_2$) geschalteten ersten Hilfsfunkenstrecke ($F_1$), welche beim Triggern die mindestens zwei Kapazitäten ($C_1$, $C_2$) in Reihe schaltet und die auf eine Zündspannung grösser als die Ladespannung jeder der mindestens zwei Kapazitäten ($C_1$, $C_2$) eingestellt ist,

- dass die Zündspannung der Funkenstrecke (20) grösser eingestellt ist als die Ladespannung jeder der min-destens zwei Kapazitäten ($C_1$, $C_2$) und kleiner als die Summe der Ladespannungen der mindestens zwei Kapazitäten ($C_1$, $C_2$), und

- dass parallel zur Funkenstrecke (20) und zur ersten Hilfsfunkenstrecke ($F_1$) jeweils eine Schaltstelle (Trenner 51) gelegt ist, welche die Funkenstrecke (20) und die erste Hilfsfunkenstrecke (F1) nach deren Auslösung leitend überbrücken.


2. Prüfkreis nach Anspruch 1, dadurch gekennzeichnet,

- dass zu einer ersten ($C_2$) der mindestens zwei pa-rallelgeschalteten Kapazitäten ($C_1$, $C_2$) mindestens eine dritte Kapazität ($C_3$) parallelgeschaltet ist,

und dass zwischen die erste Kapazität ($C_2$) und die dritte Kapazität ($C_3$) eine zweite Hilfsfunkenstrecke ($F_2$) geschaltet ist, welche auf eine Zündspannung grösser als die Ladespannung der ersten Kapazität ($C_2$) und grösser als die Ladespannung der dritten Kapazität ($C_3$) und kleiner als die Summe der Ladespannungen der ersten und der zweiten Kapazität ($C_1$, $C_2$) eingestellt ist, und welche alleine oder gemeinsam mit der ersten Hilfsfunkenstrecke ($F_1$) triggerbar ist,

- dass die Zündspannung der Funkenstrecke (20) kleiner ist als die Summe der Ladespannungen der ersten, zweiten und dritten Kapazität ($C_1$, $C_2$, $C_3$), und

- dass zur zweiten Hilfsfunkenstrecke ($F_2$) eine Schaltstelle (Trenner 51) gelegt ist, welche die zweite Hilfsfunkenstrecke ($F_2$) nach Auslösung elektrisch leitend überbrückt.

3. Prüfkreis nach Anspruch 1 oder 2, dadurch gekennzeichnet, dass der Kapazitätswert, der sich aus der Reihenschaltung der parallelgeschalteten Kapazitäten ($C_1$, $C_2$) des Stossgenerators ergibt, mindestens das Fünfbis Zehnfache des Kapazitätswertes einer zum Prüfschalter (9) parallelgeschalteten Kapazität ($C_e$) beträgt.

4. Prüfkreis nach einem der Ansprüche 1 bis 3, dadurch gekennzeichnet, dass eine erste Klemme (26) der zweiten ($C_1$) der mindestens zwei parallelgeschalteten Kapazitäten ($C_1$, $C_2$) mit einer ersten Klemme (27) der ersten Kapazität ($C_2$) über einen ersten Ladewiderstand ($R_1$) und eine zweite Klemme (25) der zweiten Kapazität ($C_1$) mit einer zweiten Klemme (28) der ersten Kapazität ($C_2$) über einen zweiten Ladewiderstand ($R_2$) verbunden ist,

und dass ferner zwischen der ersten Klemme (26) der zweiten Kapazität ($C_1$) und der zweiten Klemme (28) der ersten Kapazität ($C_2$) die ersten Hilfsfunkenstrecke ($F_1$) zwischengeschaltet ist.

5. Prüfkreis nach Anspruch 2, dadurch gekennzeichnet, dass die erste Klemme (26) der zweiten ($C_1$) der mindestens zwei parallelgeschalteten Kapazitäten ($C_1$, $C_2$) mit der ersten Klemme (27) der ersten Kapazität ($C_2$) über den ersten Ladewiderstand ($R_1$) und eine zweite Klemme (25) der zweiten Kapazität ($C_1$) mit einer zweiten Klemme (28) der ersten Kapazität ($C_2$) über den zweiten Ladewiderstand ($R_2$) verbunden ist, und dass zwischen der ersten Klemme (26) der zweiten Kapazität ($C_1$) und der zweiten Klemme (28) der ersten Kapazität ($C_2$) die erste Hilfsfunkenstrecke ($F_1$) zwischengeschaltet ist, und dass ferner die erste Klemme (27) der ersten Kapazität ($C_2$) über einen dritten Ladewiderstand ($R_3$) mit einer ersten Klemme (29) der dritten Kapazität ($C_3$) und die zweite Klemme (28) der ersten Kapazität ($C_2$) über einen vierten Ladewiderstand ($R_4$) mit einer zweiten Klemme (30) der dritten Kapazität ($C_3$) verbunden ist, wobei zwischen die erste Klemme (27) der ersten Kapazität ($C_2$) und die zweite Klemme (30) der dritten Kapazität ($C_3$) die zweite Hilfsfunkenstrecke ($F_2$) geschaltet ist.

6. Prüfkreis nach Anspruch 4, dadurch gekennzeichnet, dass parallel zum ersten Ladewiderstand ($R_1$) eine Diode (50) geschaltet ist, welche von der ersten Klemme (26) der zweiten Kapazität ($C_1$) in Richtung auf die erste Klemme (27) der ersten Kapazität ($C_2$) für angelegte Gleichspannung durchlässig ist.

7. Prüfkreis nach Anspruch 5, dadurch gekennzeichnet, dass parallel zum ersten ($R_1$) und dritten Ladewiderstand ($R_3$) jeweils eine Diode (50) geschaltet ist, welche jeweils von der ersten Klemme (26) der zweiten Kapazität ($C_1$) in Richtung auf die erste Klemme (29) der dritten Kapazität ($C_3$) für angelegte Gleichspannung durchlässig ist.

0218820

FIG.1

0218820

FIG. 2

96 / 85

Europäisches
Patentamt

# EUROPÄISCHER RECHERCHENBERICHT

**0218820**

Nummer der Anmeldung

EP 86 11 0269

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl 4) |
|---|---|---|---|
| X | GB-A- 498 570 (THE BRITISH THOMSON HOUSTON CO., LTD) * Seite 2, Zeilen 36-64; Seite 3, Zeilen 12-73,88-113; Figur 1 * | 1,2 | G 01 R 31/32 |
| A | | 4,5 | |
| | --- | | |
| A | DE-A- 692 933 (AEG) | | |
| | --- | | |
| A | NUCLEAR INSTRUMENTS AND METHODS, Band 51, Nr. 2, 1967, Seiten 293-298, North-Holland Publishing Co., Amsterdam, NL; E. NICOLAI et al.: "Eine Impulsstrahlungsquelle für ein Megavolt Summenladespannung in gedrängter Bauweise" * Seite 294, Absatz 2 - Seite 295; Figur 2 * | 1,2,4, 5 | |
| | | | **RECHERCHIERTE SACHGEBIETE (Int. Cl.4)** |
| A | DE-A-1 158 167 (LICENTIA PATENT-VERWALTUNGS-GmbH) | | G 01 R H 03 K |
| | ----- | | |

Der vorliegende Recherchenbericht wurde für alle Patentansprüche erstellt.

| Recherchenort | Abschlußdatum der Recherche | Prüfer |
|---|---|---|
| DEN HAAG | 06-01-1987 | KUSCHBERT D.E. |